# FASCICULE DE BREVET EUROPEEN

(11) **EP 1 811 549 B1**
(45) Date de publication et mention de la délivrance du brevet: **22.06.2011**
(21) Numéro de dépôt: 07290063.2
(22) Date de dépôt: 18.01.2007
(51) Int. Cl.: H01L 21/283, H01L 21/3213

(54) **Procédé de retrait sélectif d'un métal non-siliciuré**
Verfahren zur selektiven Entfernung von nicht silizidiertem Metall
Method of selectively removing non-silicided metal

(30) Priorité: 18.01.2006 FR 0600436
(43) Date de publication de la demande: 25.07.2007
(73) Titulaire: STMicroelectronics (Crolles 2) SAS, 38920 Crolles (FR)
(72) Inventeur: Halimaoui, Aomar, 38660 La Terrasse (FR)
(74) Mandataire: Zapalowicz, Francis

(56) Documents cités:
- US-A- 4 248 688
- US-A- 5 401 674
- US-A1- 2005 156 258

## Description

La présente invention concerne les circuits intégrés, et plus particulièrement la formation d'un siliciure de métal sur un composant de circuit intégré.

La réalisation de composants microélectroniques comprend souvent une étape de siliciuration d'une partie dudit composant. L'étape de siliciuration consiste en la formation d'un siliciure de métal sur une zone en silicium. Cette étape a surtout lieu au niveau des surfaces qui sont utilisées comme surfaces de contact entre le composant microélectronique et les pistes de connexion. La siliciuration permet d'obtenir une meilleure conductivité au niveau de ces surfaces grâce à l'alliage silicium/métal ainsi formé qui présente une résistance de contact très faible.

Des procédés de siliciuration sont actuellement connus et largement utilisés.

Ainsi, un procédé de siliciuration auto-aligné d'un transistor MOS est classiquement utilisé par l'homme du métier. Selon ce procédé, le métal à siliciurer est déposé sur toute la surface du transistor, c'est-à-dire sur les régions de source, de drain, de grille, sur les espaceurs isolants et sur la zone d'isolation (par exemple du type « tranchée peu profonde » (Shallow Trench Isolation)) isolant le transistor des autres composants du circuit intégré. On réalise alors un traitement thermique durant lequel le siliciure de métal se forme au niveau des zones de contact entre le silicium et le métal, c'est-à-dire au niveau des régions de source, de drain et de grille. Par contre, il n'y a pas de siliciuration au niveau des espaceurs et de la zone d'isolation qui sont constitués généralement de nitrure ou d'oxyde de silicium. Enfin, le surplus de métal restant au-dessus du siliciure de métal formé précédemment et au-dessus des espaceurs et de la zone d'isolation, est retiré à l'aide d'une solution chimique, la solution chimique étant choisie de manière à retirer sélectivement le métal et pas son siliciure.

Actuellement, les technologies CMOS utilisent le siliciure de nickel (NiSi). Un exemple de solution chimique permettant d'attaquer sélectivement le nickel et pas son siliciure est le mélange d'acide sulfurique et d'eau oxygénée dilués dans l'eau (Sulfuric Peroxyde Mixture dit « SPM »).

Cependant, pour les futures générations, il est prévu d'utiliser d'autres siliciures tels que le siliciure de platine (PtSi) ou le siliciure d'iridium (IrSi) qui présentent une plus faible résistance de contact et une meilleure stabilité. Il est même envisagé d'utiliser des siliciures de terres rares (comme l'erbium (Er) ou l'ytterbium (Yb)) pour certaines architectures.

Dans le cas du platine, la seule solution chimique actuellement connue capable de le dissoudre est l'eau régale qui est formée d'un mélange d'acide chlorhydrique concentré, d'acide nitrique concentré et d'eau. Or, l'eau régale attaque aussi le siliciure de platine, et n'est donc pas sélective vis-à-vis du platine uniquement. De plus, l'eau régale est une solution chimique très corrosive et instable dans le temps. Il s'agit donc d'une solution peu compatible avec une utilisation en milieu industriel.

Dans le cas de l'iridium, il n'y a pas de chimie connue qui permette de le dissoudre.

La solution chimique doit donc remplir au moins deux contraintes. D'une part, elle doit être capable de dissoudre le métal non-siliciuré. D'autre part, elle ne doit pas, ou peu, dissoudre le siliciure dudit métal. Ces contraintes limitent fortement le choix de la solution chimique pour les nouveaux métaux envisagés et, en général, aboutissent à des solutions très corrosives et donc peu utilisables en milieu industriel.

Le document US-A-5401674 décrit un procédé de siliciuration selon l'art antérieur.

L'invention vise à remédier à ces inconvénients.

L'invention a également pour but de proposer un nouveau procédé s'appliquant aisément à la siliciuration des nouveaux métaux envisagés tout en restant compatible avec les métaux classiquement utilisés jusqu'à maintenant, comme par exemple le nickel.

Selon un aspect de l'invention, il est proposé un procédé de siliciuration comprenant : le dépôt d'au moins un métal sur une région contenant du silicium, la formation d'un siliciure de métal et le retrait du reliquat de métal n'ayant pas été siliciuré lors de la formation du siliciure de métal. Le retrait du reliquat de métal comprend :
a) la transformation dudit reliquat de métal en un alliage contenant du germaniure dudit métal, et
b) le retrait dudit alliage par dissolution dans une solution chimique.

En d'autres termes, on remplace la couche de métal à enlever par une couche contenant du germaniure de métal dont la dissolution est plus aisée et en général sélective vis-à-vis du siliciure de métal, et qui peut s'effectuer par une solution chimique classique habituellement utilisée dans le domaine des semi-conducteurs et de la microélectronique.

Le métal comprend préférentiellement au moins un des métaux choisi dans le groupe formé par : le platine, l'iridium, l'erbium, l'ytterbium, le cobalt et le nickel.

La solution chimique comprend préférentiellement au moins un des composés choisis dans le groupe : acide sulfurique, eau oxygénée, acide chlorhydrique, ammoniaque.

Ces composés sont fréquemment utilisés dans l'industrie microélectronique. Ils sont ainsi à la base de plusieurs solutions chimiques classiques telles que le SPM (Sulfuric Peroxyde Mixture : mélange d'acide sulfurique et d'eau oxygénée dilués dans l'eau), ou bien le « SC1 » (Standard Cleaning 1 : mélange d'ammoniaque, d'eau oxygénée et d'eau), ou bien encore le « SC2 » (Standard Cleaning 2 : mélange d'acide chlorhydrique, d'eau oxygénée et d'eau). Le procédé permet donc d'une part de retirer sélectivement un métal non-siliciuré vis-à-vis de son siliciure, et d'autre part de le faire grâce à une solution chimique classique et couramment utilisée en microélectronique.

Selon un mode de mise en oeuvre, la transformation du reliquat de métal comprend le dépôt d'un matériau comprenant du germanium sur ledit reliquat de métal, suivi d'un recuit.

De manière préférentielle, le matériau comprenant du germanium a une teneur en germanium supérieure à 20%.

De manière préférentielle, le recuit de formation du germaniure de métal s'effectue à une température comprise entre 100 et 600°C.

Selon un mode de mise en oeuvre, le matériau comprenant du germanium peut être déposé par dépôt chimique en phase vapeur (CVD) avec du germane (GeH₄) comme précurseur et de préférence à une température inférieure à 400°C.

Selon un autre mode de mise en oeuvre, le matériau comprenant du germanium peut être déposé par dépôt chimique en phase vapeur assistée par plasma (PECVD) avec du germane (GeH₄) comme précurseur et de préférence à une température inférieure à 200°C.

La région contenant du silicium est l'une au moins des régions de source, de drain ou de grille d'un transistor.

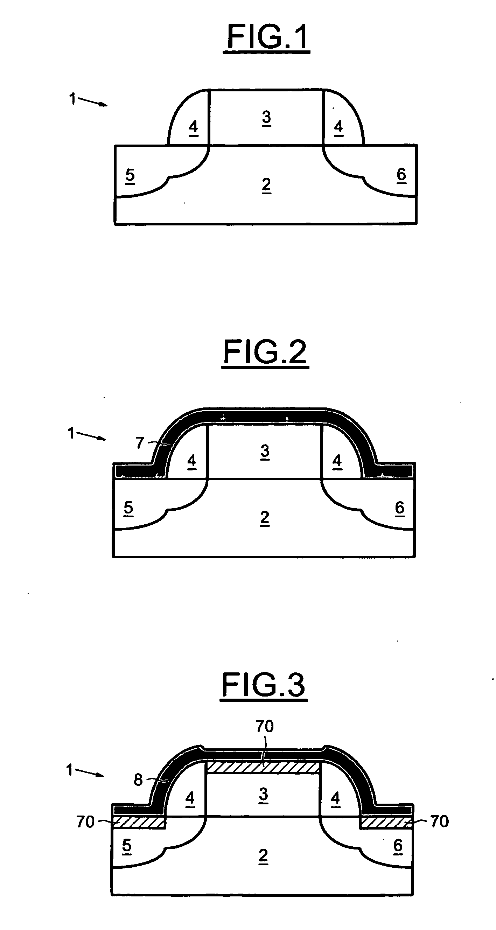

D'autres avantages et caractéristiques apparaîtront à l'examen de la description détaillée d'un mode de mise en oeuvre, nullement limitatif, et des dessins annexés sur lesquels les figures 1 à 6 illustrent d'une façon très schématique, les principales étapes d'un mode de mise en oeuvre du procédé selon l'invention.

La figure 1 représente très schématiquement une coupe d'un circuit intégré 1 comprenant un transistor réalisé sur un substrat 2. Le transistor comprend une grille 3, des espaceurs 4 placés de part et d'autres de la grille 3 et des régions de source 5 et de drain 6.

Une couche de métal 7 est déposée sur la surface du transistor, au-dessus des régions de source 5, de drain 6, de grille 3 et au-dessus des espaceurs 4. A titre d'exemple, le platine sera utilisé comme métal. On obtient le circuit intégré 1 tel que représenté sur la figure 2.

On procède ensuite à une siliciuration. Durant cette étape, on forme du siliciure de métal 70, dans le cas présent du siliciure de platine, au niveau des régions de source 5, de drain 6 et de grille 3. Par contre, le platine ne réagit pas avec les espaceurs 4 qui comprennent essentiellement du nitrure de silicium. Le platine n'ayant pas réagi se trouve à la surface du transistor et forme une couche de reliquat de métal 8 (figure 3).

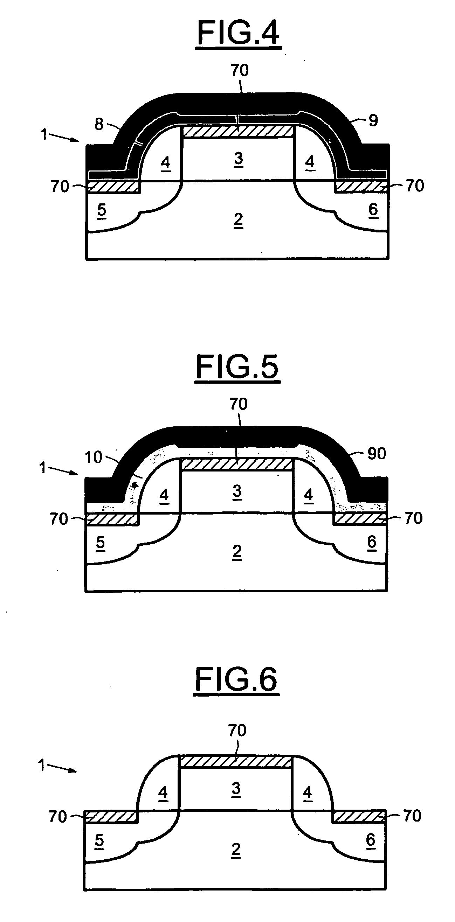

L'étape suivante consiste à déposer sur le transistor une deuxième couche 9 comprenant essentiellement du germanium. Cette couche recouvre la couche 8 de platine déposée précédemment et n'ayant pas réagi (cf. Figure 4). Aux endroits où la couche 7 a totalement réagi avec le silicium du transistor pour former le siliciure, la couche 9 se retrouve sur ladite couche de siliciure de platine 70.

Le dépôt de la couche 9 se fait préférentiellement à des températures inférieures à 400°C, par dépôt chimique en phase vapeur (CVD) avec du germane (GeH₄) comme précurseur. Des dépôts à des températures inférieures à 200°C peuvent également être obtenu soit par dépôt chimique en phase vapeur assisté par plasma (PECVD) avec du germane comme précurseur, soit par toute autre méthode telle que l'évaporation ou la pulvérisation cathodique. On peut noter également que la couche 9 n'est pas forcément une monocouche de germanium. En particulier, la couche 9 peut être formée de silicium-germanium (SiGe). Toutefois, dans ce dernier cas, le poucentage de germanium de la couche 9 est de préférence supérieur à 20%.

On réalise alors un second traitement thermique afin de former du germaniure de platine 10 au niveau des zones de contact entre la couche de platine 8 n'ayant pas été siliciurée et la couche 9. Le traitement thermique est effectué de manière à ce que tout le platine de la couche 8 soit transformé en germaniure de platine 10 (figure 5). Durant cette transformation, il faut également noter que le germanium ne réagit pas ou peu avec le siliciure de platine déjà formé car ce dernier est un matériau plus stable. Ainsi, le germanium contenu dans la couche 9 va donc réagir surtout avec le platine de la couche 8. Le recuit de transformation du platine en germaniure de platine est effectué préférentiellement à des températures comprises entre 250°C et 400°C. A l'issu de ce recuit, il reste généralement un reliquat de germanium 90.

On réalise enfin le retrait sélectif des couches 90 et 10 à l'aide d'une solution chimique standard. On pourra ainsi utiliser une solution de type « SPM », ou bien de l'acide sulfurique pur, ou bien une solution « SC1 », ou bien encore une solution « SC2 ». Ces solutions sont adaptées au milieu industriel et sont couramment utilisées en microélectronique. La solution chimique peut également être chauffée, par exemple à 70°C, afin d'accélérer la vitesse de dissolution du germanium et du germaniure de platine. Le circuit intégré obtenu est celui représenté sur la figure 6. Le transistor a été siliciuré au niveau de ses surfaces de contact et le surplus de platine a été sélectivement retiré de manière à ne plus court-circuiter le transistor.

Le procédé décrit précédemment dans le cas particulier du platine s'applique aussi avantageusement à d'autres métaux tels que le cobalt, le nickel, l'erbium, l'ytterbium ou bien encore l'iridium. En particulier, dans le cas de l'iridium dont on ne connaît aucune chimie capable de le dissoudre, le procédé tel que présenté permet non seulement de retirer l'iridium à l'aide de solutions chimiques classiques pour l'homme du métier, mais encore de retirer sélectivement l'iridium par rapport à son siliciure.

Il convient également de préciser que ces solutions sont couramment utilisées dans l'industrie électronique et que leur manipulation ne pose pas de difficultés particulières. De plus, elles sont moins corrosives que l'eau régale par exemple, et sont également moins chères.

Le procédé décrit précédemment peut également être associé au procédé « Dual silicide » qui met en oeuvre deux siliciures sur une même plaque de silicium (par exemple du siliciure de platine (PtSi) et du siliciure d'erbium (ErSi₂)).

## Revendications

1. Procédé de siliciuration, comprenant le dépôt d'au moins un métal (7) sur une région (3, 5, 6) contenant du silicium, la formation d'un siliciure de métal (70) et le retrait du reliquat de métal (8) n'ayant pas été siliciuré lors de la formation du siliciure de métal, **caractérisé par le fait que** le retrait du reliquat de métal (8) comprend :
a) la transformation dudit reliquat de métal (8) en un alliage (10) contenant du germaniure dudit métal, et
b) le retrait dudit alliage (10) par dissolution dans une solution chimique.

2. Procédé selon la revendication 1 dans lequel le métal (7) comprend au moins un des métaux choisi dans le groupe formé par: le platine, l'iridium, l'erbium, l'ytterbium, le cobalt et le nickel.

3. Procédé selon la revendication 1 ou 2 dans lequel la solution chimique comprend au moins un des composés choisis dans le groupe : acide sulfurique, eau oxygénée, acide chlorhydrique, ammoniaque.

4. Procédé selon l'une des revendications 1 à 3, dans lequel ladite transformation du reliquat de métal (8) comprend le dépôt d'un matériau (9) comprenant du germanium sur ledit reliquat de métal (8), suivi d'un recuit.

5. Procédé selon la revendication 4 dans lequel le matériau (9) comprenant du germanium a une teneur en germanium supérieure à 20%.

6. Procédé selon la revendication 4 ou 5, dans lequel le recuit s'effectue à une température comprise entre 100 et 600°C.

7. Procédé selon l'une des revendications 4 à 6 dans lequel le matériau (9) comprenant du germanium est déposé par dépôt chimique en phase vapeur (CVD) avec du germane (GeH₄) comme précurseur et de préférence à une température inférieure à 400°C.

8. Procédé selon l'une des revendications 4 à 6 dans lequel le matériau (9) comprenant du germanium est déposé par dépôt chimique en phase vapeur assistée par plasma (PECVD) avec du germane (GeH₄) comme précurseur et de préférence à une température inférieure à 200°C.

9. Procédé selon l'une des revendications précédentes dans lequel la région (3, 5, 6) contenant du silicium est l'une au moins des régions de source (5), de drain (6) ou de grille (3) d'un transistor.

## Claims

1. Silicidation method, comprising a deposition of at least one metal (7) on a silicon-containing region (3, 5, 6), the formation of a metal silicide (70) and the removal of the residue of metal (8) that has not been silicided during the formation of the metal silicide, **characterized in that** the removal of the residue of metal (8) comprises:
a) the conversion of said residue of metal (8) to an alloy (10) containing the germanide of said metal; and
b) the removal of said alloy (10) by dissolving it in a chemical solution.

2. Method according to Claim 1, in which the metal (7) comprises at least one of the metals chosen from the group formed by: platinum, iridium, erbium, ytterbium, cobalt and nickel.

3. Method according to Claim 1 or 2, in which the chemical solution comprises at least one of the compounds chosen from the group: sulphuric acid, hydrogen peroxide, hydrochloric acid and aqueous ammonia.

4. Method according to one of Claims 1 to 3, in which said conversion of the residue of metal (8) comprises the deposition of a material (9) comprising germanium on said residue of metal (8), followed by an annealing operation.

5. Method according to Claim 4, in which the material (9) comprising germanium has a germanium content of greater than 20%.

6. Method according to Claim 4 or 5, in which the annealing is carried out at a temperature between 100 and 600°C.

7. Method according to one of Claims 4 to 6, in which the material (9) comprising germanium is deposited by chemical vapour deposition (CVD) with germane (GeH₄) as precursor and preferably at a temperature below 400°C.

8. Method according to one of Claims 4 to 6, in which the material (9) comprising germanium is deposited by plasma-enhanced chemical vapour deposition (PECVD) with germane (GeH₄) as precursor and preferably at a temperature below 200°C.

9. Method according to one of the preceding claims, in which the silicon-containing region (3, 5, 6) is at least one of the source (5), drain (6) and gate (3) regions of a transistor.

## Patentansprüche

1. Silicidierungsverfahren, das die Abscheidung wenigstens eines Metalls (7) auf einem Bereich (3, 5, 6), der Silicium enthält, die Bildung eines Metallsilicids (70) und die Entfernung des Metallrests (8), der bei der Bildung des Metallsilicids nicht in Silicid umgewandelt worden ist, enthält, **dadurch gekennzeichnet, dass** die Entfernung des Metallrests (8) enthält:
a) Transformieren des Metallrests (8) in eine Legierung (10), die das Germanid des Metalls enthält, und
b) Entfernen der Legierung (10) durch Auflösen in einer chemischen Lösung.

2. Verfahren nach Anspruch 1, wobei das Metall (7) wenigstens eines der Metalle enthält, die aus der Gruppe gewählt sind, die gebildet ist aus: Platin, Iridium, Erbium, Ytterbium, Kobalt und Nickel.

3. Verfahren nach Anspruch 1 oder 2, wobei die chemische Lösung wenigstens eine der Komponenten enthält, die aus der Gruppe gewählt sind, die gebildet ist aus: Schwefelsäure, Wasserstoffperoxid, Chlorwasserstoffsäure, Ammoniak.

4. Verfahren nach einem der Ansprüche 1 bis 3, wobei die Transformation des Metallrests (8) das Abscheiden auf dem Metallrest (8) eines Materials (9), das Germanium enthält, gefolgt von einem Glühen, enthält.

5. Verfahren nach Anspruch 4, wobei das Material (9), das Germanium enthält, einen Germaniumanteil von mehr als 20 % besitzt.

6. Verfahren nach Anspruch 4 oder 5, wobei das Glühen bei einer Temperatur im Bereich von 100 bis 600 °C erfolgt.

7. Verfahren nach einem der Ansprüche 4 bis 6, wobei das Material (9), das Germanium enthält, durch chemische Abscheidung aus der Dampfphase (CVD) mit German (GeH₄) als Vorläufer und vorzugsweise bei einer Temperatur niedriger als 400 °C abgeschieden wird.

8. Verfahren nach einem der Ansprüche 4 bis 6, wobei das Material (9), das Germanium enthält, durch plasmagestützte chemische Abscheidung aus der Dampfphase (PECVD) mit German (GeH₄) als Vorläufer und vorzugsweise bei einer Temperatur niedriger als 200 °C abgeschieden wird.

9. Verfahren nach einem der vorhergehenden Ansprüche, wobei der Bereich (3, 5, 6), der Silicium enthält, ein Source-Bereich (5) und/oder ein Drain-Bereich (6) und/oder ein Gate-Bereich (3) eines Transistors ist.
